# EUROPEAN PATENT APPLICATION

(11) **EP 4 572 551 A1**
(43) Date of publication of application: **18.06.2025**
(21) Application number: 23852741.0
(22) Date of filing: 29.06.2023
(51) Int. Cl.: H05K 7/20, H05K 5/00

(54) **ELECTRONIC DEVICE**

(30) Priority: 12.08.2022 KR 20220101627; 12.08.2022 KR 20220101628
(71) Applicant: LG INNOTEK CO. LTD, Gangseo-gu Seoul 07796 (KR)
(72) Inventor: HWANG, Ga Hee, Seoul 07796 (KR); SONG, Kun Yong, Seoul 07796 (KR)
(74) Representative: DREISS Patentanwälte PartG mbB
(86) International application number: PCT/KR2023/009180
(87) International publication number: WO 2024/034854

(57) **Abstract**

This electronic device comprises: a housing having a space therein and including a heat-dissipation passage penetrating from one side to another side; an electronic part disposed in the space; and a heat-dissipation member which is disposed in the heat-dissipation passage and in which coolant flows, wherein the heat-dissipation passage includes a hole facing the electronic part, and the heat-dissipation member is disposed so as to at least partially overlap the electronic part in the up/down direction through the hole.

## Description

### [Technical Field]

The teachings in accordance with exemplary and non-limiting embodiments of the present invention relate generally to an electronic device.

### [Background Arts]

The electronic devices in a vehicle are generally the engine electrical system (starter, ignition, charging system) and the lighting system, but recently, as vehicles have become more electronically controlled, most systems, including the chassis electrical system, are becoming more electronic.

The various electronic devices installed in vehicles, such as lamps, audio, heaters, and air conditioners, are powered by the battery when the vehicle is stopped and by the generator when the vehicle is in motion. At this time, the power generation capacity of the 14V power system is used as the normal power supply voltage.

In recent years, with the development of the information technology industry, various new technologies (motor-driven power steering, internet, etc.) have been incorporated into vehicles to increase the convenience of automobiles, and it is expected that the development of new technologies that can make the most of the current automotive system will continue in the future.

The electronic device is shaped by the housing. Inside the housing, a number of electronic parts for driving are placed. The above-mentioned multiple electronic parts generate heat by driving.

### [Detailed Description of the Invention]

### [Technical Subject]

The present exemplary embodiment provides an electronic device that can improve heat dissipation efficiency while reducing weight.

### [Technical Solution]

In one general aspect of the present invention, there may be provided an electronic device comprising: a housing having a space therein and including a heat-dissipation passage penetrating from one side to another side; an electronic part disposed in the space; and a heat-dissipation member which is disposed in the heat-dissipation passage and in which coolant flows, wherein the heat-dissipation passage includes a hole facing the electronic part, and the heat-dissipation member is disposed so as to at least partially overlap the electronic part in the up/down direction through the hole.

Preferably, but not necessarily, the housing may be made of plastic and the heat-dissipation member may be made of metal.

Preferably, but not necessarily, the housing and the heat-dissipation member may be integrally formed by insert injection.

Preferably, but not necessarily, a lower surface of the heat- dissipation member facing the electronic part may be a flat surface.

Preferably, but not necessarily, the heat-dissipation member may include a heat-dissipation plate with an upper surface in contact with the heat-dissipation passage and a lower surface in contact with the electronic part.

Preferably, but not necessarily, the heat-dissipation plate may be screwed to an inner surface of the housing.

Preferably, but not necessarily, the inner surface of the housing may include a guide which is protruded more than other regions, and to which the heat-dissipation plate is attached, and the guide may be divided into multiple regions by the heat-dissipation passage.

Preferably, but not necessarily, each of the multiple regions may be screwed together with the heat-dissipation plate and the electronic part.

Preferably, but not necessarily, a region of the upper surface of the electronic part that is in contact with the heat-dissipation plate may include a metal material.

Preferably, but not necessarily, a protrusion that protrudes upward from the other regions may be formed in a region of the upper surface of the housing corresponding to the formation area of the heat-dissipation passage.

### [Advantageous Effects]

The present exemplary embodiment has the advantage of improving the heat-dissipation efficiency of the electronic device due to the structure in which the heat-dissipation member through which the coolant flows and the electronic parts are contacted or directly contacted through the heat-dissipation plate.

In addition, the metal heat-dissipation member is integrally formed with the plastic housing, which has the advantage of making the electronic device lightweight and reducing the manufacturing cost.

### [Brief Description of Drawings]

FIG. 1 is a perspective view of one side of the electronic device according to a first exemplary embodiment of the present invention.
FIG 2 is a perspective view of the other side of the electronic device according to a first exemplary embodiment of the present invention.
FIG. 3 is a plan view of a lower surface of the electronic device according to a first exemplary embodiment of the present invention.
FIG. 4 is a perspective view of a housing, a heat-dissipation plate, and electronic parts according to a first exemplary embodiment of the present invention.
FIG. 5 is a perspective view of a housing, a heat-dissipation member, a heat-dissipation plate, and an electronic part according to the first exemplary embodiment of the present invention.
FIG. 6 is a exploded view of a housing and a heat-dissipation member according to a first exemplary embodiment of the present invention.
FIG. 7 is a plan view showing a combined structure of an electronic part and a heat-dissipation member according to a first exemplary embodiment of the present invention.
FIG. 8 is a perspective view of one side of an electronic device according to a second exemplary embodiment of the present invention.
FIG. 9 shows a perspective view of the other side of the electronic device according to a second exemplary embodiment of the present invention.
FIG. 10 is a top view of the electronic device according to a second exemplary embodiment of the present invention.
FIG. 11 is a drawing showing A-A' of FIG. 10.
FIG. 12 is an exploded perspective view of an electronic device according to a second exemplary embodiment of the present invention.
FIG. 13 is a drawing showing FIG. 12 from a different angle.

### [Best Mode]

Hereinafter, exemplary embodiments of the present invention will be described in detail with reference to the accompanying drawings.

However, the present invention is not limited to the given exemplary embodiments described, but may be implemented in a variety of different forms, and one or more of components among the exemplary embodiments may be optionally combined or substituted between embodiments within the scope of the present invention.

Furthermore, terms (including technical and scientific terms) used in the embodiments of the present invention, unless expressly specifically defined and described, are to be interpreted in the sense in which they would be understood by a person of ordinary skill in the art to which the present invention belongs, and commonly used terms, such as dictionary-defined terms, are to be interpreted in light of their contextual meaning in the relevant art.

Furthermore, the terms used in the embodiments of the invention are intended to describe the embodiments and are not intended to limit the invention.

In this specification, the singular may include the plural unless the context otherwise requires, and references to "at least one (or more) of A and (or) B and C" may include one or more of any combination of A, B, and C that may be assembled.

In addition, the terms first, second, A, B, (a), (b), and the like may be used to describe components of embodiments of the invention. Such terms are intended only to distinguish one component from another, and are not intended to limit the nature or sequence or order of such components by such terms.

Furthermore, when a component is described as "connected," "coupled," or "attached" to another component, it can include cases where the component is "connected," "coupled," or "attached" to the other component directly, as well as cases where the component is "connected," "coupled," or "attached" to another component that is between the component and the other component.

Furthermore, when described as being formed or disposed "above" or "below" each component, "above" or "below" includes not only when two components are in direct contact with each other, but also when one or more other components are formed or disposed between the two components. Furthermore, when expressed as "above" or "below", it may include the meaning of upward as well as downward with respect to a single component.

The electronic device according to the exemplary embodiments of the present invention may be equipped in the vehicle and may include a converter, a pump, and an electronic control unit (ECU). However, this is an example, and the electronic device may include at least one or more electronic parts arranged in a housing, and various devices electrically connected via external terminals and connectors.

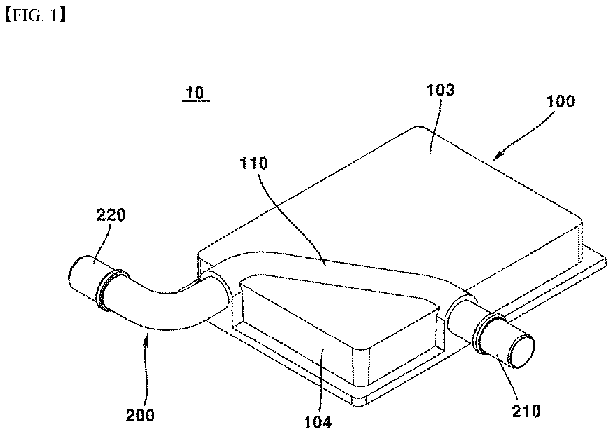

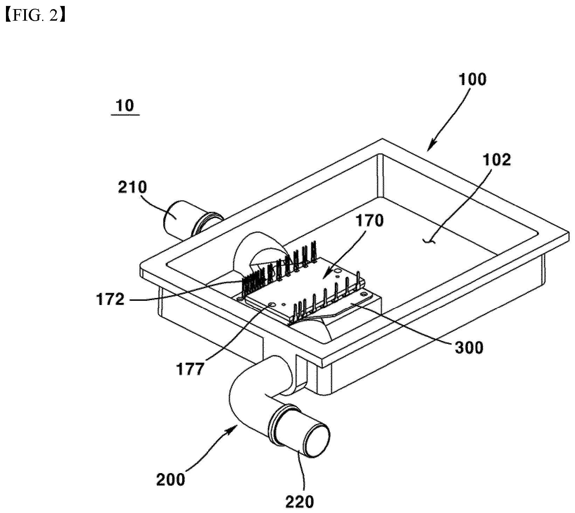

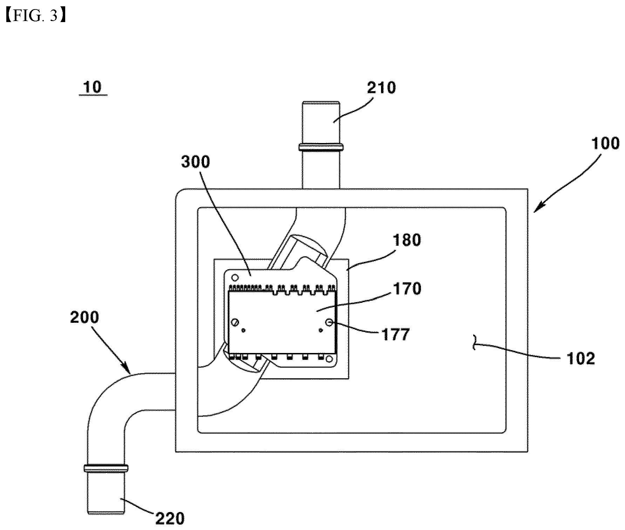

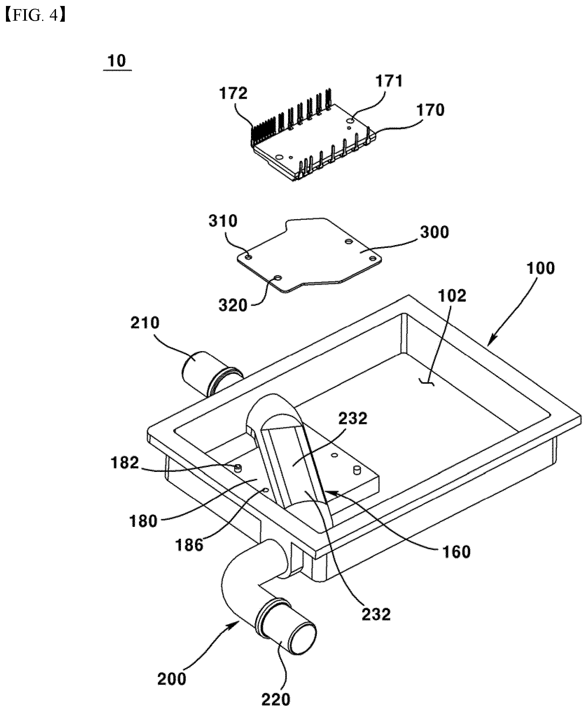

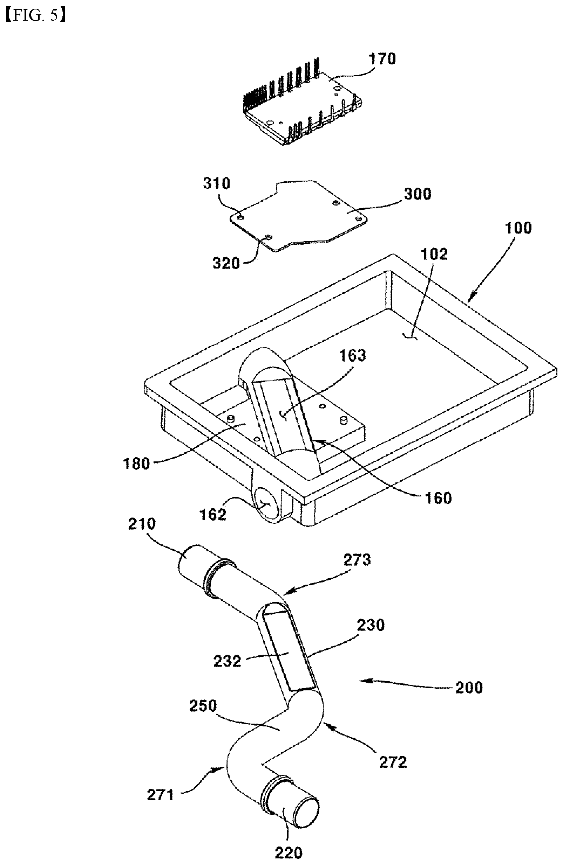

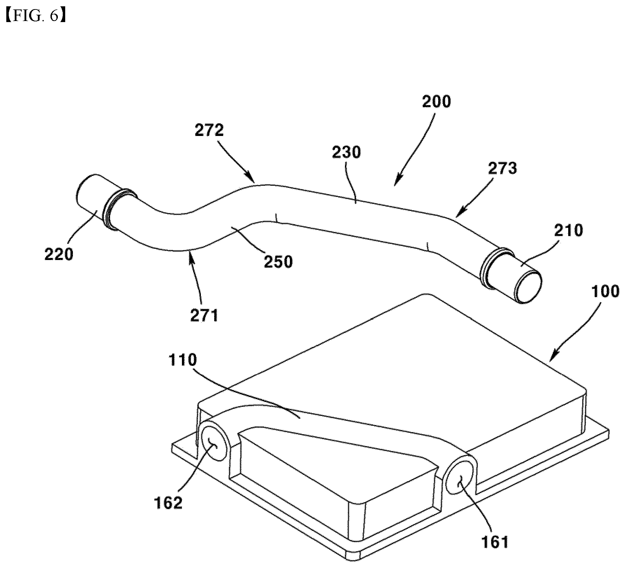

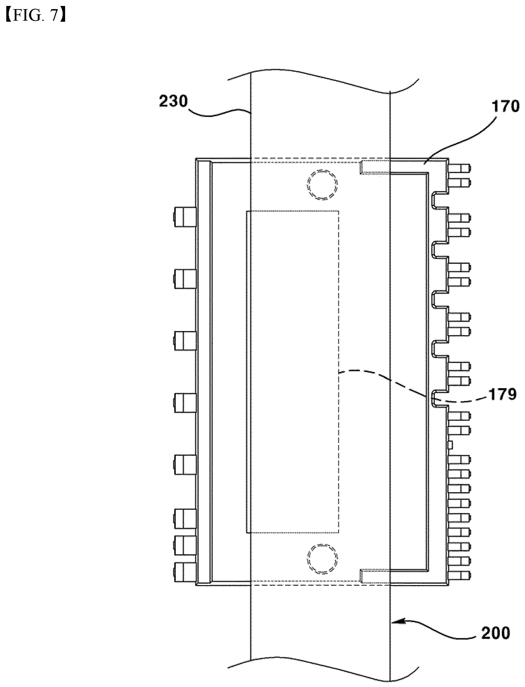

FIG. 1 is a perspective view of one side of the electronic device according to a first exemplary embodiment of the present invention, FIG 2 is a perspective view of the other side of the electronic device according to a first exemplary embodiment of the present invention, FIG. 3 is a plan view of a lower surface of the electronic device according to a first exemplary embodiment of the present invention, FIG. 4 is a perspective view of a housing, a heat-dissipation plate, and electronic parts according to a first exemplary embodiment of the present invention, FIG. 5 is a perspective view of a housing, a heat-dissipation member, a heat-dissipation plate, and an electronic part according to the first exemplary embodiment of the present invention, FIG. 6 is a exploded view of a housing and a heat-dissipation member according to a first exemplary embodiment of the present invention, and FIG. 7 is a plan view showing a combined structure of an electronic part and a heat-dissipation member according to a first exemplary embodiment of the present invention.

Referring to FIGS. 1 to 7, an electronic device (10) according to a first embodiment of the present invention may include a housing (100), an electronic part (170), and a heat-dissipation member (200).

The housing (100) may form the outer shape of the electronic device (10). The housing (100) may have a rectangular cross-sectional shape. The housing (100) may be shaped like a box. At least one or more parts for driving the electronic device (10) including the electronic part (170) may be placed in a space (102) within the housing (100). The space (102) in the housing (100) may be opened downward. A cover (not shown) may be attached to a lower surface of the housing (100) to cover a lower surface of the space (102).

The housing (100) may include an upper plate (103) and a side plate (104) that extends downward from an edge of the upper plate (103). The upper plate (103) may form an upper surface of the electronic device (10). The side plate (104) may form the side of the electronic device (10). At least one hole or groove may be formed in the side plate (104). External terminals can be coupled with the housing (100) through the holes or grooves.

A plurality of regions may be formed on the upper surface of the housing (100) that are arranged in a staggered (stair-cased) manner. Some of the multiple regions may have a shape that protrudes upward or may be recessed downward compared to other areas.

The housing (100) may include a heat-dissipation passage (160). The heat-dissipation passage (160) is a region in which at least a portion of the heat-dissipation member (200) is placed, and may be formed within the housing (100). One side of the housing (100) may be formed with a first opening (161, see FIG. 6) that forms one end of the heat-dissipation passage (160), and the other side of the housing (100) may be formed with a second opening (162) that forms the other end of the heat-dissipation passage (160). The heat dissipation-passage (160) may be formed as a single line defined from the first opening (161) to the second opening (162). The cross-section of the heat-dissipation passage (160) may be formed to correspond to the cross-section shape of the heat-dissipation member (200). For example, the heat-dissipation passage (160) may be circular in shape.

The heat-dissipation passage (160) may have a region that is bent at least once. The heat-dissipation passage (160) may be arranged in an overlapping manner with the electronic part (170) in the up/down direction. One side of the housing (100) in which the first opening (161) is formed and the other side of the housing (100) in which the second opening (162) is formed can be placed next to each other. One side of the housing (100) in which the first opening (161) is formed and the other side of the housing (100) in which the second opening (162) is formed can be positioned perpendicularly to each other.

A protrusion (110) that protrudes upward from the region of the housing (100) that corresponds to the formation area of the heat- dissipation passage (160) may be formed in the region of the upper surface of the housing (100) that corresponds to the formation area of the heat-dissipation passage (160). The heat dissipation passage (160) may be formed on the inside of the protrusion (110).

A hole (163) may be formed in a lower surface of the heat- dissipation passage (160) facing the electronic part (170). The hole (163) may be arranged to overlap the electronic part (170) in the vertical direction. The space in the heat dissipation channel (160) may be opened downward by the hole (163). When the heat- dissipation passage (160) is viewed from the side, the hole (163) may have an arc-shaped cross-section. The space in the heat- dissipation passage (160) can be exposed downward through the hole (163). Through the hole (163), the heat-dissipation member (200) can be exposed downward, which is the direction facing the electronic part (170).

A rib (not shown) that protrudes downward may be formed on the lower surface of the above-mentioned upper plate (103). The surface area of the housing (100) can be increased by the rib. As a result, the heat-dissipation efficiency of the housing (100) can be improved.

A connector (not shown) may be placed on the side of the housing (100). Depending on the material characteristics of the housing (100), the connector may be formed as a single body with the housing (100).

The material of the housing (100) may be plastic. Accordingly, the electronic device (10) can be made lightweight.

The housing (100) may include a guide (180). As shown in FIG. 4, the guide (180) may have a shape that protrudes downward from the lower surface of the upper plate (103). The guide (180) may be placed on the outside of the heat-dissipation passage (160). The guide (180) may have a rectangular cross-sectional shape. The guide (180) may be divided into two regions by the heat-dissipation passage (160). The guide (180) may be placed outside the area where the hole (163) is formed in the heat-dissipation passage (160). The lower surface of the guide (180) may be positioned above the lower surface of the heat-dissipation passage (160). The lower surface of the guide (180) may be positioned above the lower surface of the heat-dissipation member (200). However, this is an example, and the lower surface of the guide (180) may be positioned so that it forms the same plane as the lower surface of the flat surface (232) inside the heat-dissipation passage (160) and the heat- dissipation member (200) described later.

On the lower surface of the guide (180), a guide protrusion (182) and a first screw hole (186) may be formed. The guide protrusion (182) may have a shape that protrudes downward from the lower surface of the guide (180). The guide protrusion (182) may be provided in multiple numbers and may be arranged facing each other with respect to the heat-dissipation passage (160). The guide protrusions (182) may be placed in the corner area of the lower surface of the guide (180). The first screw hole (186) may have a shape that is recessed upward from the lower surface of the guide (180) in a different area. A thread or a thread groove may be formed on the inner surface of the first screw hole (186). The first screw hole (186) may be provided in multiple numbers and may be arranged at a distance from each other. Multiple first screw holes (186) may be arranged opposite each other with respect to the heat-dissipation passage (160).

At least one electronic part may be placed in the space (102) within the housing (100). A printed circuit board (not shown) may be placed in the space (102) within the housing (100). The printed circuit board may be formed in a plate shape, and at least one or more parts for driving may be placed (mounted) on one side or the other side.

The space (102) within the housing (100) may be arranged with electronic part (170). The electronic part (170) may be mounted on the upper surface of the printed circuit board. The electronic part (170) may include a plurality of pins (172) for coupling with the printed circuit board. The electronic part (170) may include a core and a plurality of pins (172) extending from the side of the core. The electronic part (170) may generate heat by being driven. The electronic part (170) may be placed on the lower surface of the upper plate (103) of the housing (100).

The electronic part (170) may be arranged in an overlapping manner with the heat-dissipation passage (160) in the up/down direction. The electronic part (170) may be arranged to overlap at least part of the heat-dissipation member (200) in the up/down direction. The electronic part (170) may be arranged to overlap the hole (163) of the heat-dissipation passage (160) in the up/down direction. The heat- dissipation passage (160) may be arranged to overlap the guide (180) in the up/down direction.

The electronic part (170) may be screwed to the lower surface of the guide (180).

To this end, the electronic part (170) may include a second screw hole (171) facing the first screw hole (186). Like the first screw hole (186), the second screw hole (171) may be provided with multiple holes and may be arranged at a mutual distance. When the electronic part (170) and the guide (180) are combined, the screw (177) may be threaded through the second screw hole (171) and threaded into the first screw hole (186).

The electronic device (10) may include a heat-dissipation member (200). The heat-dissipation member (200) may have a flow path formed so that coolant flows thereinside. The heat-dissipation member (200) may be formed in the shape of a pipe. The heat- dissipation member (200) may have a circular cross-section. The heat-dissipation member (200) may be placed within the heat- dissipation passage (160). Both ends of the heat-dissipation member (200) may protrude from the outer surface of the housing (100) through the first opening (161) and the second opening (162) of the heat-dissipation passage (160). The heat-dissipation member (200) may be exposed at least partially to the downward direction of the space (102) within the housing (100) through the hole (163). The heat-dissipation member (200) may be placed opposite the electronic part (170) through the hole (163).

The heat-dissipation member (200) may be formed of metal. The heat-dissipation member (200) may be integrally formed with the housing (100) of the plastic material by insert injection.

At one end of the heat dissipation member (200), a coolant inlet (210) for introducing coolant into the flow path may be formed, and at the other end of the heat-dissipation member (200), a coolant outlet (220) for discharging the coolant that has circulated in the flow path may be formed. The coolant inlet (210) and the coolant outlet (220) may be arranged in parallel.

The coolant inlet (210) and the coolant outlet (220) may be arranged in parallel. The heat-dissipation member (200) may be formed as a single line defined from the coolant inlet (210) to the coolant outlet (220). As mentioned above, the regions where the coolant inlet (210) is located and the region where the coolant outlet (220) is located may be mutually perpendicular to each other. The heat-dissipation member (200) may have at least one bent area.

In detail, the heat-dissipation member (200) may include a contact portion (230) that is disposed between the coolant inlet (210) and the coolant outlet (220). The contact portion (230) may be bent from the end of the coolant inlet (210) and extend toward the coolant outlet (220). The contact portion (230) may be positioned at an obtuse angle to the coolant inlet (210) or the coolant outlet (220). The contact portion (230) may be arranged to connect one side and the other side of the housing (100) that are placed in mutual adjacency. A first bent portion (273) may be formed between the contact portion (230) and the coolant inlet (210).

The contact portion (230) may be disposed within the heat-dissipation passage (160). The contact portion (230) may be exposed at the lower surface of the space (102) within the housing (100) through the hole (163). The lower surface of the contact portion (230) may be disposed facing the electronic part (170). A flat surface (232) may be formed on the lower surface of the contact portion (230) that is exposed through the hole (163) to the lower surface of the heat-dissipation passage (160). The heat-dissipation member (200) other than the contact portion (230) is a pipe having a circular cross-sectional shape, but the cross-sectional region of the contact portion (230) formation region may not be circular due to the flat surface (232).

The flat surface (232) may be so formed as to be stair-cased upwardly from other areas of the heat-dissipation member (200). Based on the lower surface of the heat-dissipation member (200), the formation region of the flat surface (232) may have a groove shape.

The flat surface (232) may be formed by press-processing the heat-dissipation member (200). Before the insert injection of the housing (100) and the heat- dissipation member (200), the flat surface (232) may be previously formed within the heat-dissipation member (200).

The flat surface (232) may be formed in a region facing the electronic part (170) or the heat-dissipation plate (300, to be described later), among the lower surface of the contact portion (230). The flat surface (232) may be a surface parallel to the upper surface or the lower surface of the upper plate (103) of the housing (100). The flat surface (232) may be a surface parallel to the upper surface of electronic part (170) or the upper surface of the heat dissipation plate (300). The flat surface (232) may be in contact with the upper surface of the heat dissipation plate (300) or the upper surface of the electronic part (170). An inclined surface may be formed on the surface connecting the flat surface (232) and the other area within the heat-dissipation member (200).

The heat-dissipation member (200) may include a connection portion (250) in addition to the contact portion (230), and the connection portion (250) may be connected to both ends to the contact portion (230) and the coolant outlet (220). The connection portion (250) may be positioned perpendicularly to the coolant inlet (210) or the coolant outlet (220). The connection portion (250) may be positioned to form an obtuse angle with the contact portion (230). The connection portion (250) may be positioned at least partially outside the heat-dissipation passage (160).

A second bent portion (272) may be formed between the connection portion (250) and the contact portion (230), and a third bent portion (271) may be formed between the connection portion (250) and the coolant outlet (220).

The first bent portion (273) and the second bent portion (272) may be arranged to overlap in the up/down direction with the housing (100).

The electronic device (10) may include a heat dissipation plate (300). The heat-dissipation plate (300) may be placed between the lower surface of the guide (180) and the upper surface of the electronic part (170). The heat-dissipation plate (300) may be placed between the lower surface of the contact portion (230) exposed downward through the hole (163) and the upper surface of the electronic part (170). The heat-dissipation plate (300) may be disposed between the flat surface (232) and the upper surface of the electronic part (170). The heat-dissipation plate (300) may have its upper surface in contact with the flat surface (232) and its lower surface in contact with the upper surface of the electronic part (170).

The heat-dissipation plate (300) may have a plate shape and may be made of metal. The heat-dissipation plate (300) may include a guide hole (310) into which the guide protrusion (182) is engaged, and a third screw hole (186) facing the first screw hole (186) and the second screw hole (171). When the heat-dissipation plate (300) and the guide (180) are combined, the guide protrusion (182) may be combined with the guide hole (310).

In addition, the screw (177) can be screwed into the first screw hole (186) through the second screw hole (171) and the third screw hole (186).

A heat-dissipation tape (not shown) made of a material with excellent heat conductivity may be disposed between the heat-dissipation plate (300) and the upper surface of the electronic part (170). The heat-dissipation tape may have adhesive material applied to one or both sides, allowing the heat-dissipation plate (300) and the electronic part (170) to be bonded together.

Meanwhile, as shown in FIG. 7, a metal plate (179) made of metal may be formed on the lower surface of the heat-dissipation plate (300) or on the upper surface of the electronic part (170) in contact with the flat surface (232). The metal plate (179) may be exposed upward from the upper surface of the core in the electronic part (170) and may be contacted with the lower surface of the heat- dissipation plate (300).

According to the above structure, the structure in which the heat-dissipation member through which the coolant flows and the electronic part are contacted through the heat-dissipation plate has the advantage of improving the heat dissipation efficiency of the electronic device.

In addition, the metal heat-dissipation member is integrated into the plastic housing, which has the advantage of making the electronic device lighter and reducing manufacturing costs.

The following describes an electronic device according to the second exemplary embodiment of the present invention.

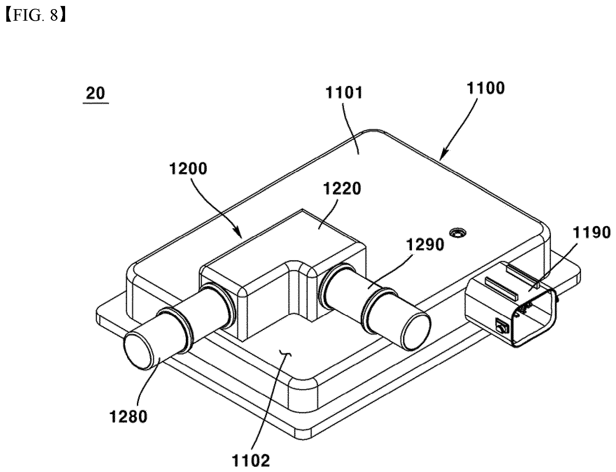

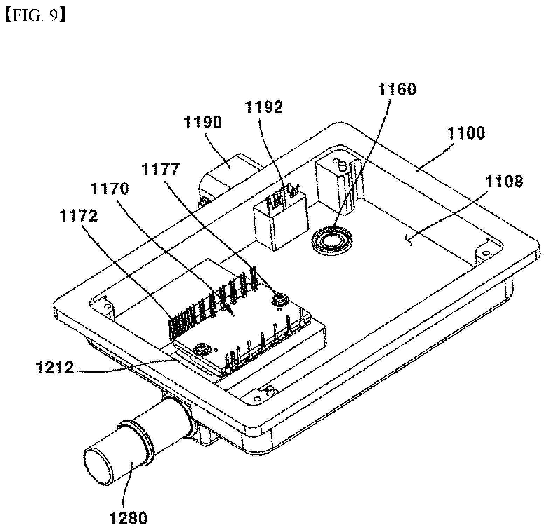

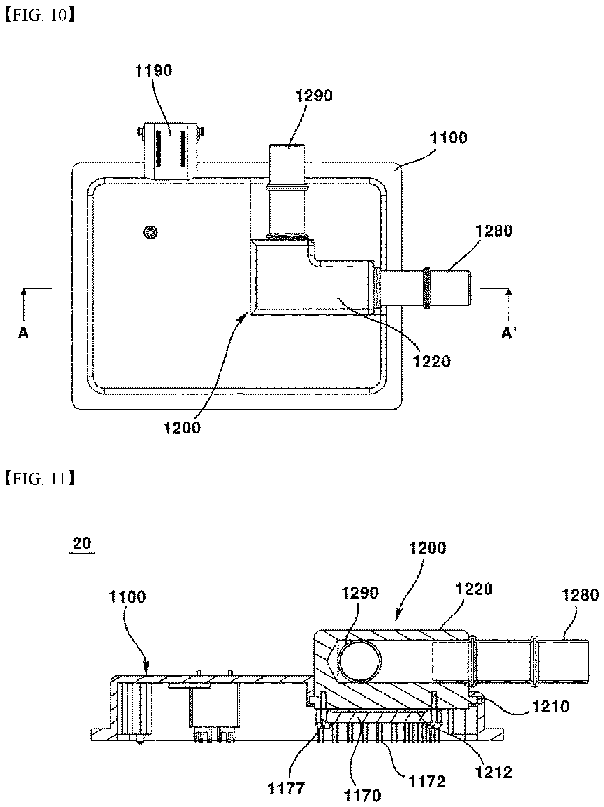

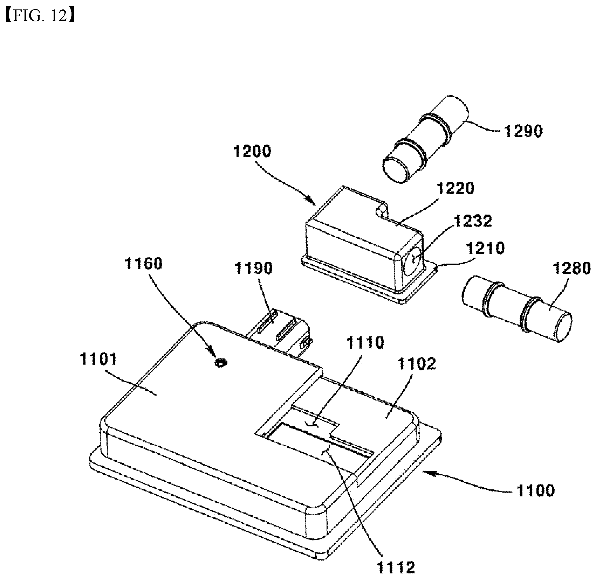

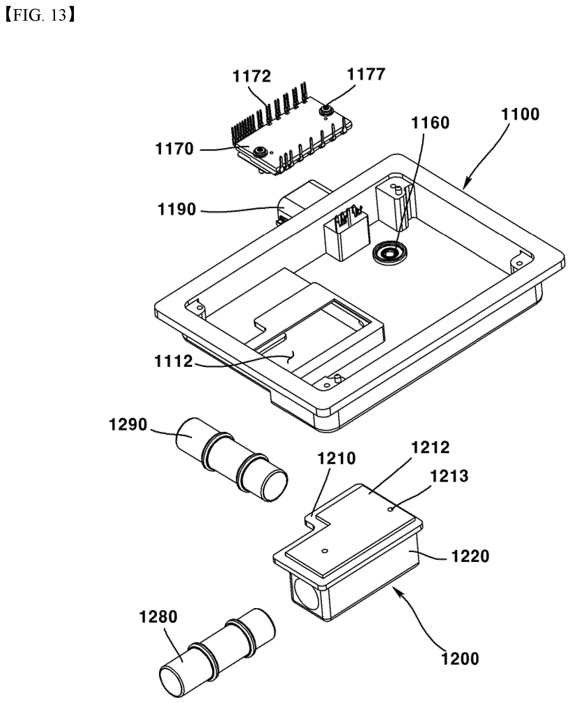

FIG. 8 is a perspective view of one side of an electronic device according to a second exemplary embodiment of the present invention, FIG. 9 shows a perspective view of the other side of the electronic device according to a second exemplary embodiment of the present invention, FIG. 10 is a top view of the electronic device according to a second exemplary embodiment of the present invention, FIG. 11 is a drawing showing A-A' of FIG. 10, FIG. 12 is an exploded perspective view of an electronic device according to a second exemplary embodiment of the present invention, and FIG. 13 is a drawing showing FIG. 12 from a different angle.

Referring to FIGS. 8 to 13, an electronic device (20) according to a second exemplary embodiment of the present invention may include a housing (1100), an electronic part (1170), and a heat dissipation member (1200).

The housing (1100) may form an outer shape of the electronic device (20). The housing (1100) may have a rectangular cross-sectional shape. The housing (1100) may be shaped like a box. At least one configuration for driving the electronic device (20) including the electronic part (1170) may be disposed in a space (1108) within the housing (1100). The space (1108) within the housing (1100) may be opened downward. A cover (not shown) may be coupled to the lower surface of the housing (1100) to cover the lower surface of the space (1108).

The housing (1100) may include an upper plate and a side plate that is bent and extends downward from the edge of the upper plate. The upper plate may form an upper surface of the electronic device (20). The side plate may form a side of the electronic device (20).

At least one hole or groove may be formed in the side plate. The external terminals may be coupled with the configuration disposed within the housing (1100) through the holes or grooves.

On the upper surface of the housing (1100) mentioned above, multiple regions may be formed that are staggered (stair-cased) in terms of their mutual positions. The upper surface of the housing (1100) may include a first region (1101) and a second region (1102). The upper surface of the first region (1101) may be disposed above the upper surface of the second region (1102). The upper surface of the second region (1102) may be disposed stair-casedly lower than the upper surface of the first region (1102).

On the upper surface of the second region (1102), a coupling groove (1110) and a hole (1112) may be formed, each of which is coupled to the heat dissipation member (1200) to be described later. The coupling groove (1110) may be formed by being recessed from the upper surface of the second region (1102) to a predetermined distance downward. The lower surface of the coupling groove (1110) may be formed with a step (staircasedly) lower than the upper surface of the second region (1102). A base (1210) of the heat dissipation member (1200) described later may be coupled to the coupling groove (1110). The cross-sectional shape of the coupling groove (1110) may be formed corresponding to the cross-sectional shape of the base (1210). The cross-section of the coupling groove (1110) may have a shape of approximately '¬' or ' 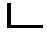 '.

The hole (1112) may be formed to penetrate the lower surface of the upper plate from the bottom surface of the coupling groove (1110). The heat dissipation plate (1212) of the heat dissipation member (1200) described later may be disposed in the hole (1112). The hole (1112) may have a cross-sectional shape of an approximately '¬' character. The cross-sectional area of the hole (1112) may be smaller than the cross-sectional area of the coupling groove (1110).

The region of the lower surface of the upper plate corresponding to the formation area of the coupling groove (1110) may be shaped to protrude downward from other areas.

A connector (1190) may be disposed on the side of the housing (1100). The connector (1190) may be so disposed as to penetrate the side of the housing (1100). An external terminal (not shown) may be coupled to the connector (1190), and power may be supplied to the electronic device (20) or control signals related to the operation of the electronic device (20) can be transmitted and received by coupling the external terminal. A connector pin may be disposed within the inner space of the connector (1190), and it can be electrically connected to a printed circuit board (not shown) placed within the space (1108) of the housing (1100). Depending on the material properties of the housing (1100), the connector (1190) may be formed as a single unit with the housing (1100).

A protrusion (not shown) that protrudes downward may be formed on the lower surface of the housing (1100) upper plate. The surface area of the housing (1100) can be increased by the above-mentioned protrusion. As a result, the heat dissipation efficiency of the housing (1100) can be improved.

The housing (1100) may be made of plastic. Accordingly, the electronic device (20) can be made lightweight.

The housing (1100) may include an air vent structure. The air vent structure may include an air hole penetrating the inner surface from the outer surface of the housing (1100) and a thin film (1160) arranged to cover the air hole. The hole may be placed in the first region (1101). The thin film (1160) may be made of a material that is breathable and waterproof, and can be disposed to cover the hole. The thin film (1160) may be thermally coupled to the hole within the housing (1100).

At least one electronic part may be disposed within the space (1108) within the housing (1100). A printed circuit board (not shown) may be disposed within the space (1108) within the housing (1100). The printed circuit board may be formed in the shape of a plate, and at least one or more parts for driving may be disposed (mounted) on one side or the other side. The printed circuit board may be coupled with connector pins of the connector (1190).

An electronic part (1170) may be disposed in the space (1108) within the housing (1100). The electronic part (1170) may be mounted on one side of the printed circuit board. The electronic part (1170) may include a plurality of pins (1172) for coupling with the printed circuit board. The electronic part (1170) may include a core and a plurality of pins (1172) extending from the side of the core. The electronic component (1170) may generate heat by operation.

The electronic part (1170) may be disposed on the lower surface of the upper plate of the housing (1100). The electronic device (20) may include a heat dissipation member (1200). The heat dissipation member (1200) may be disposed so that at least a portion of it penetrates the housing (1100). The heat dissipation member (1200) may include a body (1220), a first pipe (1280), a second pipe (1290), and a heat dissipation plate (1212).

The body (1220) may be disposed on the upper surface of the housing (1100). The cross-section of the body (1220) may be roughly shaped like the letter '¬'. A flow path through which coolant flows may be formed in the body (1220). On one side of the body (1220), a first opening (1232) forming one end of the flow path is formed, and on the other side of the body (1220), a second opening forming the other end of the flow path may be formed. The first opening (1232) may be called a coolant inlet. The second opening may be named a coolant outlet.

The flow path may be formed as a single line defined from the first opening (1232) to the second opening. The flow path may have at least one bend. The flow path may be arranged to overlap the electronic part (1170) in the up/down direction. One side of the body (1220) in which the first opening (1232) is formed and the other side of the body (1220) in which the second opening is formed may be disposed perpendicularly to each other.

A base (1210) having a larger cross-sectional area than other areas may be formed at a lower end of the body (1220). The base (1210) may be formed as one body with the body (1220). The cross-section of the base (1210) may be formed to correspond to the cross-section shape of the coupling groove (1110). The base (1210) may be in the shape of a plate with a predetermined thickness. The base (1210) may be in contact with the bottom surface of the coupling groove (1110).

The body (1220) and the base (1210) may be formed of metal and may be formed as one body. The body (1220) and the base (1210) may be integrally formed by insert injection with the housing (1100), which is made of plastic.

The first pipe (1280) may be coupled to the first opening (1232). The first pipe (1280) may be in the shape of a pipe. The coolant may be introduced into the flow path in the body (1220) through the first pipe (1280). The first pipe (1280) may be a coolant inlet.

The second pipe (1290) may be coupled to the second opening. The second pipe (1290) may be in the shape of a pipe. The coolant in the flow path may be discharged to the outside through the second pipe (1290). The second pipe (1290) may be a coolant outlet.

However, this is an example, and the second pipe (1290) may be the coolant inlet, and the first pipe (1280) may be the coolant outlet.

The first pipe (1280) and the second pipe (1290) may be arranged perpendicularly to each other on the housing (1100).

The heat dissipation plate (1212) may be coupled to the lower surface of the body (1220). The heat dissipation plate (1212) may be coupled to the lower surface of the base (1210). The cross-sectional shape of the heat dissipation plate (1212) may be formed to correspond to the cross-sectional shape of the hole (1112). The heat dissipation plate (1212) may be made of metal and may be formed as one body with the body (1220) and the base (1210). The lower surface of the heat dissipation plate (1212) may be disposed downwardly and stepped (stair-cased) with respect to the lower surface of the base (1210).

A first screw hole (1213) may be formed on the lower surface of the heat dissipation plate (1212). The first screw hole (1213) may be provided in multiple numbers and may be spaced apart from each other.

The lower surface of the heat dissipation plate (1212) may be coupled with the electronic part (1170). The lower surface of the heat dissipation plate (1212) and the upper surface of the electronic part (1170) may be in contact. The lower surface of the heat dissipation plate (1212) may be in contact with the upper surface of the core of the electronic component (1170). The electronic part (1170) may be screwed to the heat dissipation plate (1212). A second screw hole may be formed in the area facing the first screw hole (1213) in the electronic part (1170). Therefore, when the screw (1177) penetrates the second screw hole and is coupled to the first screw hole (1213), the electronic part (1170) can be screwed to the lower surface of the heat dissipation plate (1212). The second screw hole may also be provided in multiple numbers corresponding to the number of the first screw hole.

In addition to the above screw coupling, a heat-dissipation tape (not shown) made of a material with excellent heat conductivity may be disposed between the lower surface of the heat dissipation plate (1212) and the upper surface of the electronic part (1170). The heat-dissipation tape may have adhesive material applied to one or both sides, allowing the heat-dissipation plate (1212) and the electronic part (1170) to be coupled together.

According to the above structure, the structure in which the heat-dissipation member through which the coolant flows is directly contacted with the electronic part has the advantage of improving the heat-dissipation efficiency.

In addition, the metal heat dissipation member is integrally formed with the plastic housing, which has the advantage of reducing the weight of the electronic device and lowering the manufacturing cost.

In the above, it is not necessarily limited to this embodiment, even though all components constituting the embodiment of the present invention are described as combined or operated by combining them. In other words, within the scope of the present invention, all components may selectively combine and operate with one or more of them. In addition, the terms 'include,' 'comprise,' or 'have,' as used herein, unless specifically stated to the contrary, are intended to mean that the component may be inherent, and should be interpreted to include other components rather than exclude other components. All terms, including technical or scientific terms, have the same meaning as generally understood by a person with ordinary skill in the art to which the invention pertains, unless otherwise defined. Terms that are commonly used, such as dictionary terms, should be interpreted in a manner consistent with their contextual meaning in the relevant art, and should not be interpreted in an idealized or overly formal sense unless explicitly defined in the present invention.

The above description is merely an illustrative example of the technical idea of the present invention, and a person with ordinary knowledge in the technical field to which the present invention belongs will be able to make various modifications and variations within the scope that does not deviate from the essential characteristics of the present invention. Therefore, the embodiments disclosed in the present invention are not intended to limit the technical idea of the present invention, but are intended to explain it, and the scope of the technical idea of the present invention is not limited by these embodiments. The scope of protection of the present invention should be interpreted by the following claims, and all technical ideas within the scope of the equivalent thereof should be interpreted as being included in the scope of protection of the present invention.

## Claims

1. An electronic device comprising:
a housing having a space therein and including a heat-dissipation passage penetrating from one side to another side;
an electronic part disposed in the space; and
a heat-dissipation member which is disposed in the heat-dissipation passage and in which coolant flows,
wherein the heat-dissipation passage includes a hole facing the electronic part, and the heat-dissipation member is disposed so as to at least partially overlap the electronic part in up/down direction through the hole.

2. The electronic device of claim 1, wherein the housing is made of plastic and the heat-dissipation member is made of metal.

3. The electronic device of claim 2, wherein the housing and the heat-dissipation member are integrally formed by insert injection.

4. The electronic device of claim 1, wherein a lower surface of the heat-dissipation member facing the electronic part is a flat surface.

5. The electronic device of claim 1, wherein the heat-dissipation member includes a heat-dissipation plate with an upper surface in contact with the heat-dissipation passage and a lower surface in contact with the electronic part.

6. The electronic device of claim 5, wherein the heat-dissipation plate is screwed to an inner surface of the housing.

7. The electronic device of claim 6, wherein the inner surface of the housing includes a guide which is protruded more than other regions, and to which the heat-dissipation plate is attached, and the guide is divided into multiple regions by the heat-dissipation passage.

8. The electronic device of claim 7, wherein each of the multiple regions is screwed together with the heat-dissipation plate and the electronic part.

9. The electronic device of claim 5, wherein a region of the upper surface of the electronic part that is in contact with the heat-dissipation plate includes a metal material.

10. The electronic device of claim 1, wherein a protrusion that protrudes upward from the other regions is formed in a region of an upper surface of the housing corresponding to a formation area of the heat-dissipation passage.
